(19) **Europäisches Patentamt**
**European Patent Office**
**Office européen des brevets**

(11) **EP 0 669 691 B1**

(12) **EUROPÄISCHE PATENTSCHRIFT**

(45) Veröffentlichungstag und Bekanntmachung des Hinweises auf die Patenterteilung:
**14.05.1997 Patentblatt 1997/20**

(51) Int Cl.⁶: **H02H 3/093**, H02H 1/00

(21) Anmeldenummer: **94102676.7**

(22) Anmeldetag: **23.02.1994**

(54) **Schaltungsanordnung für Einrichtungen zum Messen und Überwachen elektrischer Ströme**

Circuit for devices for measuring and monitoring electrical currents

Circuit pour dispositifs pour mesurer et contrôler des courants électriques

(84) Benannte Vertragsstaaten:
**CH DE ES FR IT LI**

(43) Veröffentlichungstag der Anmeldung:
**30.08.1995 Patentblatt 1995/35**

(73) Patentinhaber: **SAIA-Burgess Electronics AG**
**CH-3280 Murten (CH)**

(72) Erfinder:
• **Töpfer, Horst, Dipl.-Ing.**
**D-02779 Grosschönau (DE)**

• **Heinrich, Gerd, Dr.-Ing.**
**D-01159 Dresden (DE)**

(74) Vertreter: **Ilberg, Roland W., Dipl.-Ing. Pat.-Ing.**
**Am Weissiger Bach 93**
**01474 Schönfeld-Weissig (DE)**

(56) Entgegenhaltungen:
**GB-A- 2 028 034**      **GB-A- 2 047 995**

**Beschreibung**

Die Erfindung betrifft eine Schaltungsanordnung für Einrichtungen zum Messen und Überwachen elektrischer Ströme mit einer digitalen Meßwertverarbeitung, insbesondere für elektronische Überstromrelais.

Schaltungsanordnungen der gattungsgemäßen Art werden bereits zur Überwachung von Motoren eingesetzt. Sie sollen eine übermäßige Erwärmung des Motors durch rechtzeitiges Abschalten verhindern.

Üblicherweise werden zum Schutze von Motoren Bimetallrelais verwendet. Diese wandeln den zu überwachenden Motorstrom über die Zwischenstufe "Wärmeenergie" mittels der Bimetalle in einen Ausbiegeweg um, mit dessen Hilfe beim Überschreiten einer gewissen Wirkgrößenhöhe Schaltkontakte betätigt werden, die den gefährdeten Motor abschalten.

Ein Nachteil dieser Bimetallrelais besteht in dem kleinen Einstellbereich der Geräte, der zu einer Vielzahl von Varianten führt, um einen größeren Strombereich abzudecken. Weitere entscheidende Nachteile sind im hohen Eichaufwand, in der hohen Eigenerwärmung und in einer oftmals unbefriedigenden Wiederholgenauigkeit des Auslösezeitpunktes zu sehen.

Es ist bereits eine elektronische Überstrom-Schutzeinrichtung bekannt, die einen induktiven Stromwandler und eine analoge Meßwertverarbeitung besitzt (Prospekt der Fa. SDS Relais, 12/89). Auch hier wird für jeden Strombereich ein besonderes Gerät benötigt. Aufgrund der analogen Meßwertverarbeitung ist die Auslöse-Wiederholgenauigkeit eingeschränkt. Auch fehlt ein potentialgetrennter Ausgangskontakt.

Mit einer analog arbeitenden Einrichtung nach der DE 33 16 350 A1 lassen sich zusätzlich die Kupfer- und Eisenverluste eines Motors berücksichtigen.

Aus der US-PS 4 275 445 ist eine digitale elektronische Überstrom-Schutzeinrichtung bekannt, bestehend aus einer Analog/ Digital-Wandlung der Strommeßsignale, einem Mikroprozessor zur Signalverarbeitung, einem Ausgangsrelais und Anzeigeelementen, wobei das Auslösesignal nach der Beziehung:

$$t_a = (K/i^2 - 1)$$

mit $i = (I/I_{Nenn})$ bestimmt wird.

Ferner ist aus der DE 32 46 329 Al ein elektronisches Überstromrelais mit einem Sättigungswandler, einem nachgeschalteten Gleichrichter, einem Analog/Digital-Wandler, einem Mikroprozessor und einem Ausgangsrelais bekannt.

Ein weiteres digitales Überstromrelais zum Schutze von Motoren ist aus EP 0 214 025 bekannt.

Alle vorgenannten Schutzeinrichtungen arbeiten mit Stromwandlern zur Überstromerfassung und sind folglich entsprechend räumlich groß und auf einen bestimmten Nennstrombereich zugeschnitten. Weiterhin erfolgt die Verarbeitung der Strommeßsignale mittels relativ aufwendiger Schaltungen und Rechenverfahren.

Aus der Zeitschrift IEEE Transactions on Power Apparatus and Systems, Vol. PAS-104, Nr. 7, Juli 1985 ist der Einsatz magnetfeldabhängiger Bauelemente (Hall-Elemente) zur Stromerfassung im Bereich ab 100 A für Niederspannungs-Leistungsschalter bekannt. Unterhalb dieses Nennstrombereichs erfolgt die Stromerfassung ebenfalls mittels klassischer Stomwandler.

Letztlich ist in der GB-A-2 028 034 noch eine Schaltungsanordnung für Einrichtungen zum Messen und Überwachen elektrischer Ströme mit einer digitalen Meßwertverarbeitung offenbart.

Diese Anordnung weist magnetfeldabhängige Sensoren zur potentialgetrennten Stromerfassung, Mittel zur Nachbildung einer Strom-Zeit-Kennlinie und Mittel zur Bewertung der Meß- und Eingangssignale und Ableitung von Ausgangssignalen daraus ab.

Als magnetfeldabhängiger Sensor wird ein sogenanntes Träger-Domäne-Magnetometer (C.D.M.) eingesetzt, worunter eine Halbleitereinrichtung verstanden sein soll, die eine Ausgangsfrequenz in Abhängigkeit von der Magnetflußdichte und der angelegten Spannungen und Ströme erzeugt. Ferner umfaßt die Anordnung einen Speicher, in dem die Relais-Kennlinie abgespeichert ist und einen getakteten Zähler, der die verstrichene Zeit seit Auftreten des Überstroms erfaßt. Sobald ein Überlaststrom für eine durch die eingespeicherte Relaiskennlinie vorgegebene Zeitdauer aufgetreten ist, wird ein Relaisunterbrecher betätigt.

Die Einrichtung ist aufgrund der verwendeten Komponenten relativ teuer, insbesondere wird zur Verwaltung der einprogrammierten Relais-Kennlinie ein hoher Speicherbedarf benötigt. Das Auslöseverhalten kann zwar durch umständliches Auswechseln oder Neuprogrammieren des Speichers geändert werden, was aber von der Bedienung klassischer Überstromrelais weit entfernt ist und Spezialkenntnisse erfordert, sofern ein Auswechseln überhaupt am Einsatzort in Frage kommt. Weiterhin überstreicht jede Einrichtung nur jeweils einen Meßbereich und kann somit nicht universell eingesetzt werden. Ferner ist die Einrichtung auch nicht in der Lage, funktionell ein klassisches thermisches Bimetallrelais zu ersetzen, da die Abschaltzeit völlig unabhängig von der Betriebsart, z.B. Tippbetrieb oder ganz allgemein "alternierender Betrieb", in welche auch Abkühlphasen während des Betriebes eingehen, errechnet wird.

Der Erfindung liegt die Aufgabe zugrunde, eine einfache und kostengünstige Schaltungsanordnung zum Messen und Überwachen von Strömen, insbesondere für elektronische Überstromrelais, zu schaffen, die den Strombereich mehrerer konventioneller Einrichtungen abdeckt, eine hohe Wiederholgenauigkeit besitzt, sowie anwenderfreundlich zu bedienen und zu installieren ist.

Die Aufgabe wird erfindungsgemäß gelöst, indem

(a) zur Abdeckung eines großen Einsatzfeldes mehrere umschaltbare Meßbereiche vorgesehen sind,
(b) zur Einstellung des Auslösewertes der Anordnung über sämtliche Meßbereiche ein einziges analoges Einstellmittel (12) dient,
(c) die je Meßbereich von den Sensoren (1) abgegebenen unterschiedlichen Stromausgangssignale ($I_K$) auf über alle Meßbereiche gleichgroße Spannungssignale gebracht,
(d) abgetastet und als digitalisierte Meßwerte zwecks Nachbildung eines Strom-Zeitverhaltens in einem Zeitfenster aufsummiert und nach der Berechnungsvorschrift

$$Mittelwert_{neu} = Mittelwert_{alt} * (1-1/n) + Mittelwert_{aktuell} * (1/m),$$

mit $n$, $m$ als auslösezeitbestimmende Konstanten arithmetisch gemittelt werden und
(e) die Anordnung in einer Ausführung zur Anwendung kommt, die in Bauform und Funktionalität einem Bimetallrelais entspricht.

Die erfindungsgemäße Schaltungsanordnung weist neben dem Vorteil einer kleinen Ausführung und einem relativ geringen Bauelemente- und Speicheraufwand den deutlichen Vorteil gegenüber vergleichbaren Einrichtungen aus, daß mit einer ausgeführten Einrichtung nicht nur ein Strombereich abgedeckt wird, sondern etwa zehn Strombereiche. Dies erlaubt einen universellen Einsatz einer einzigen Einrichtung für die häufigsten Anwendungsarten und erleichtert damit die Herstellung und Lagerhaltung beträchtlich. Der Anwender legt sich erst zum Zeitpunkt des Gebrauchs auf den betötigten Einsatzfall fest, indem er am Einstellmittel den benötigten Meßbereich wählt. Zusätzlich kann er in bekannter Weise den z.B. an einen Motor angepaßten Auslöse-Nennstrom genau einstellen.

Aufgrund der digitalen Meßwertverarbeitung wird dabei eine sehr genaue Auslöse-Wiederholbarkeit erreicht, zumal infolge der Anwendung des Kompensationsprinzips äußere Temperaturschwankungen kompensiert werden und sich ebenfalls nicht auf das Auslöseverhalten auswirken.

Aufgrund der Kleinheit der Bauelemente, insbesondere der Sensoren und dem geringen Schaltungsaufwand werden Einrichtungen möglich, die als Überlastrelais zum Schutze von Motoren direkt und in gleicher Weise wie ein herkömmliches Bimetallrelais an ein Schaltschütz anbaubar sind.

Vorteilhafte Weiterbildungen der Erfindung sind in den Unteransprüchen 2 bis 14 offenbart.

Die Anwendung der Erfindung für ein elektronisches Überstromrelais soll nachstehend als Ausführungsbeispiel unter Bezugnahme auf die zugehörigen Zeichnungen näher erläutert werden.

**Fig. 1**     ist ein Blockschaltbild nach der Erfindung.

**Fig. 2**     zeigt den ausführlichen Stromlaufplan.

**Fig. 3**     zeigt die Ansicht eines Überstromrelais.

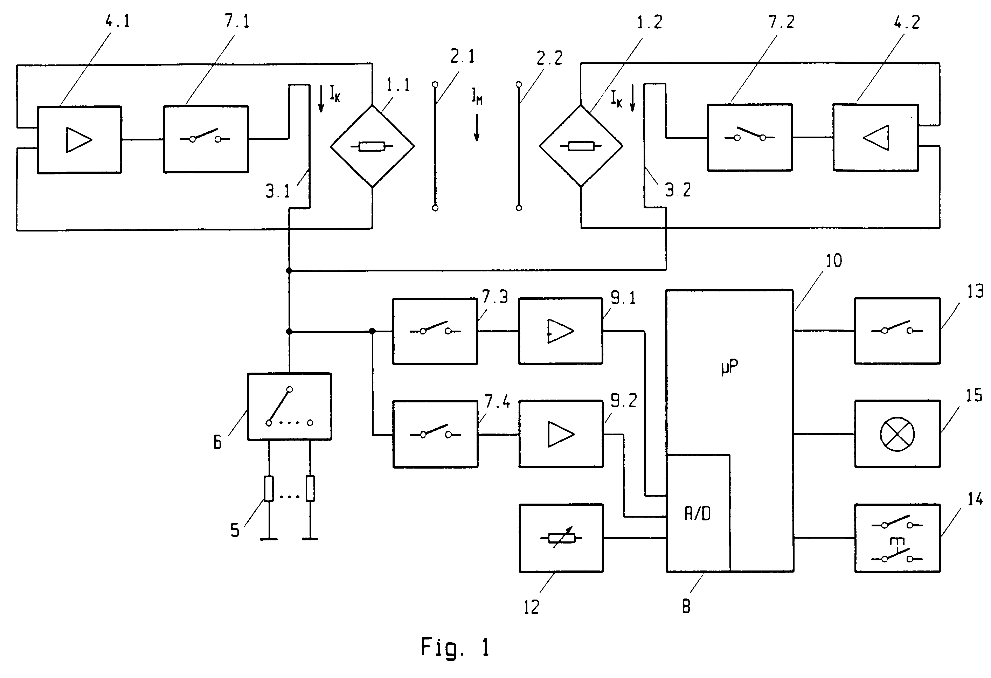

In **Fig. 1** sind die wesentlichen Bestandteile der Schaltung in Form eines Blockschaltbildes gezeigt. Danach wird der Motorstrom $I_M$ in zwei von drei Phasen mittels zweier Sensoren 1 über die Magnetfelder, welche sich um die stromdurchflossenen Leiter 2 ausbilden, gemessen. Zur Reduzierung von Fehlereinflüssen erfolgt die Stromerfassung mittels des Kompensationsprinzips. Die dazu notwendigen Kompensationsleiter 3 sind in den Sensoren 1 integriert. Die Kompensationsströme $I_K$ sind ein lineares Abbild der Meßströme $I_M$ und werden durch Verstärker 4 bereitgestellt. Sie können über einen sehr großen Bereich genau erfaßt werden. Ein weiterer Vorzug des Kompensationsprinzips besteht auch in der Möglichkeit, mittels verschiedener Meßwiderstände 5 eine Anpassung des Meßsignals an den entsprechenden Meßbereich vorzunehmen. Die Umschaltung der Meßbereiche erfolgt durch den Anwender mittels eines mechanischen Umschalters 6. Um die Meßwiderstände 5 und den Umschalter 6 nicht doppelt ausführen zu müssen, werden die Kompensationsströme $I_K$ der Sensoren 1 wechselseitig auf das Widerstandsnetzwerk 5 geschaltet. Dazu werden elektronische Schalter 7 verwendet. Die Zuschaltzeit der Sensoren 1 beträgt dabei jeweils ca. 200 bis 300 ms.

Mittels dieses einfachen und damit kostengünstigen Aufbaus gelingt es, die von den Sensoren 1 kommenden Signale (Kompensationsströme $I_K$) durch die Wahl des Strombereichs mittels des Umschalters 6 auf einen für alle verfügbaren Strombereiche gleichen Signalpegel zu normieren. Dies hat den Vorteil, daß für die Signalanpassung an einen A/D-Wandler 8 nur je ein Verstärker 9 benötigt wird und für den Mikroprozessor 10 keine Rückmeldung über den gewählten Strombereich notwendig ist.

Die Pegelanpassung, notwendig durch die unterschiedlichen Empfindlichkeiten der Sensoren 1, wird durch Wechselspannungsverstärker 9 vorgenommen. Gleichzeitig erfolgt eine gleichspannungsmäßige Entkopplung der Meßsignale. Dadurch werden Offset- und Driftgrößen, die verschiedene Ursachen haben können, weitgehend unterdrückt. Außerdem wird die Höhe des Meßsignals an den Eingangsbereich des A/D-Wandlers 8 angepaßt und mit Hilfe einer geeigneten Beschaltung der Eingänge des A/D-Wandlers 8 auf eine Gleichrichtung des Meßsignals verzichtet.

Die Meßsignale liegen an einem Port des internen A/D-Wandlers 8 des Mikroprozessors 10 an. Sie werden mit einer Frequenz von 2 kHz abgetastet. Die Abtastwerte werden in einem Zeitfenster von 240 ms aufsummiert und arithmetische Mittelwerte gebildet. Der neue Mittelwert wird gebildet nach der Berechnungsvorschrift: $Mittelwert_{neu} = Mittelwert_{alt}*(1-1/n) + Mittelwert_{aktuell}*(1/m)$ , mit $n$, $m$ als zeitbestimmende Konstanten. Der Auslösewert wird rechnerisch aus dem digitalisierten Wert eines Potentiometers 12 ermittelt. Überschreitet der neue Mittelwert den Auslösewert, kommt es zur Auslösung eines Relais 13 und damit im allgemeinen zur Abschaltung des Meßstromes $I_M$. Dadurch wird der Meßwert Null, und es kommt zu einer kontinuierlichen Verringerung des Mittelwertes. Wird ein bestimmter Grenzwert unterschritten, kann das Relais 13 automatisch oder per Hand wieder rückgestellt werden. Die Auslösezeiten ergeben sich entsprechend Strom-Zeit-Kennlinien nach IEC 947 und die Abkühlzeiten durch Anwendung der Berechnungsvorschrift.

Die Signale "Hand/Automatik" und "Test/Reset" werden dem Mikroprozessor 10 über einen Schalter 14 zugeführt.

In Abhängigkeit von allen Eingangssignalen erfolgt die Auslösung des Relais 13 und die Aktivierung einer optischen Anzeige 15.

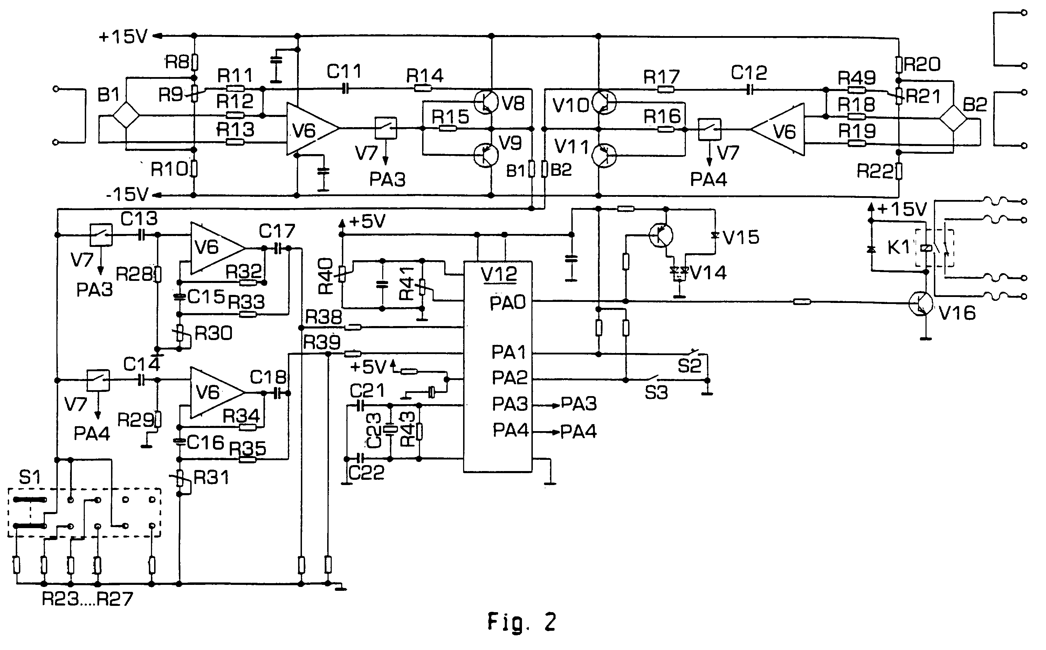

In **Fig. 2** ist der wesentliche Teil des Stromlaufplanes der Schaltung gezeigt. Durch das Magnetfeld um die stromdurchflossenen Leiter wird die Brücke in den magnetoresistiven Sensoren B1 und B2 verstimmt.

Die Spannungsversorgung der Sensoren B1, B2 erfolgt über die Widerstände R8/R10 und R20/R22. Die Brückenausgangsspannung liegt über die Widerstände R12/R13 bzw. R18/R19 an den Eingängen der Operationsverstärker V6 an. Zur Kompensation der Offsetspannung wurden die Widerstände R9/R11 und R21/R49 vorgesehen. Die Ausgangssignale der Operationsverstärker V6 gelangen über die CMOS-Schalter V7 und die Widerstände R15 bzw. R16 zu den komplementären Verstärkerstufen V8/V9 bzw. V10/ V11. Diese Verstärkerstufen V8/V9, V10/V11 liefern bei Bedarf den entsprechend hohen Kompensationsstrom. Das RC-Glied R14/ C11 bzw. R17/C12 unterdrückt hochfrequente Schwingungen. Die Widerstände R15 und R16 minimieren die Übernahmeverzerrungen bei kleinen Signalen. Die Ausgangssignale der Verstärkerstufen V8/V9 und V10/V11 werden auf die Kompensationswiderstände der Sensoren B1, B2 geschaltet. Damit ist der Regelkreis geschlossen.

Der Strom durch die Kompensationsleiter wird als Meßsignal ausgewertet. Die Bereichsumschaltung erfolgt über einen Schiebeschalter S1 auf die Meßwiderstände R23 ... R27.

Über die Analogschalter V 7 wird entweder das Signal aus Sensor B1 oder Sensor B2 auf die Meßwiderstände R23 ... R27 geschaltet und anschließend wieder auf die entsprechenden Wechselspannungsverstärker V6, C13, R28, R30, C15, R32, R33, C17 und V6, C14, R29, C16, R31, R34, R35, C18 verteilt.

Durch das wechselseitige Schalten des Kompensationsstromes wird die Stromversorgung weniger belastet. Über die Wechselspannungsverstärker wird das Signal an den internen A/D-Wandler eines Mikrocontrollers V12 angepaßt. Von diesem sind lediglich die Ports PA0 bis PA4 näher bezeichnet. Über die Widerstände R30, R31 wird die Verstärkung eingestellt. Um eine Gleichrichtung des Meßsignals einzusparen, wird nur die positive Halbwelle ausgewertet.

Die negative Halbwelle wird über die internen Schutzdioden der Eingänge des A/D-Wandlers abgeleitet. Durch die Widerstände R38 und R39 wird der Ableitstrom auf ein unkritisches Maß begrenzt.

Der Mikrocontroller V12 beinhaltet einen A/D-Wandler mit mehreren Kanälen. Über den Widerstand R40 wird die Referenzspannung eingestellt. Der Widerstand R41 ist ein von außen zugängliches Potentiometer, mit dem der Auslösewert (Motornennstrom) eingestellt werden kann. Der Prozessortakt wird durch die Bauelemente C21 ... C23 und einen Widerstand R43 erzeugt.

Mit einem Schiebeschalter S3 kann die Betriebsart "Automatische Rückstellung" oder "Handrückstellung" vorgewählt werden.

Ein Taster S2 dient dem Rücksetzen in der Stellung "Handrückstellung". Außerdem kann über ihn die Auslösung des Relais K1 simuliert werden (Testfunktion). Eine LED V14 wird als Anzeige für die Betriebsspannung (grün) und den Auslösezustand (rot) genutzt. Eine Diode V15 erhöht die Flußspannung im "grünen Zweig" der LED V14 und sorgt dafür, daß es nicht zu einer Farbmischung kommt. Ein Transistor V16 arbeitet als Treiber für das Ausgangsrelais K1.

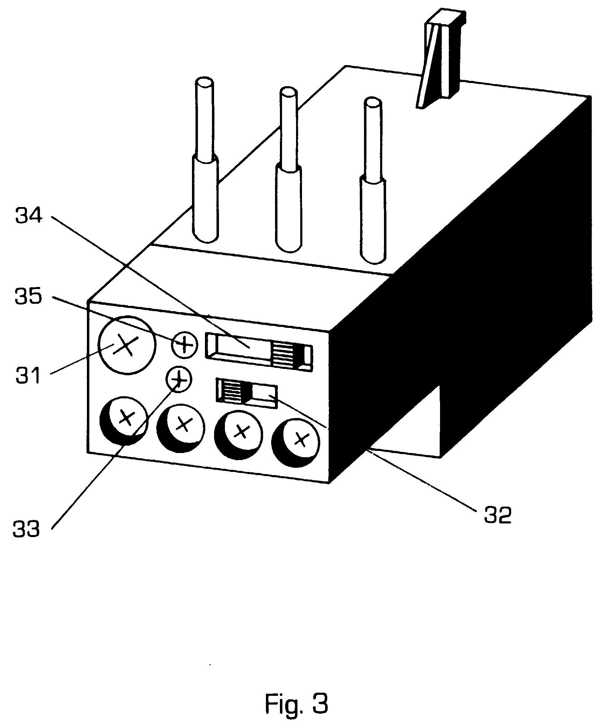

**Fig. 3** zeigt den Einsatz der erfindungsgemäßen Schaltung in einem Motorschutzrelais. Es unterscheidet sich in der äußeren Gestalt und den äußeren Abmessungen nicht von einem herkömmlichen Bimetall-Relais zur Befestigung an einem nicht näher dargestellten elektromagnetischen Schaltschütz. Auf der Oberseite befinden sich bekannterweise ein Drehknopf 31 zur Motor-Nennstromeinstellung, ein Umschalter 32 von "Automatische Rückstellung" auf "Handrückstellung" und eine Test/Auslösetaste 33. Zusätzlich ist ein Schiebeschalter 34 vorgesehen, mittels dessen der Meßbereich eingestellt werden kann. Die Anzeige der Betriebsbereitschaft des Gerätes und einer Auslösung erfolgt über eine LED 35.

Beispielsweise sind folgende Meßbereiche mit nur einer Relaisgröße mittels des Schiebeschalters 34 einstellbar:

a) 0,1 A - 0,316 A
b) 0,316 A - 1,0 A
c) 1,0 A - 3,16 A
d) 3,16 A - 10,0 A
e) 10,0 A - 31,6 A.

Vorteilhafterweise trägt der Drehknopf 31 zur Motor-Nennstromeinstellung zwei Skalen, die jede Meßbereichsdekade über den Faktor "Quadratwurzel aus 10" aufteilen. Durch diese Aufteilung wird jede Skala mehreren Meßbereichen zugeordnet, wobei der Einstellumfang für alle Meßbereiche gleich ist. Dementsprechend deckt eine Skala die Meßbereiche a), c) und e) und die andere Skala die Meßbereiche b) und d) ab.

Das beschriebene Überstromrelais wird wie ein herkömmliches Bimetallrelais angeschlossen, weshalb problemlos ein Austausch mit einem solchen möglich ist. Mit ihm steht ein universelles und verlustleistungsarmes Überstromrelais zur Verfügung, das gegenüber herkömmlichen Bimetallrelais zudem gegen äußere Temperaturschwankungen unempfindlicher ist.

Weitere Anwendungsgebiete der erfindungsgemäßen Schaltungsanordnung sind z.B. der Einsatz in Phasenausfallschutzrelais, Stromüberwachungsrelais und Asymmetrierelais.

## Patentansprüche

1. Schaltungsanordnung für Einrichtungen zum Messen und Überwachen elektrischer Ströme mit einer digitalen Meßwertverarbeitung, insbesondere für elektronische Überstromrelais, wobei die zu überwachenden Ströme über magnetfeldabhängige Sensoren potentialgetrennt erfaßt werden, geeignet bewertet werden und in Abhängigkeit dieser Bewertung ein Ausgangssignal abgeleitet wird, dadurch gekennzeichnet, daß

(a) zur Abdeckung eines großen Einsatzfeldes mehrere umschaltbare Meßbereiche vorgesehen sind,
(b) zur Einstellung des Auslösewertes der Anordnung über sämtliche Meßbereiche ein einziges analoges Einstellmittel (12) dient,
(c) die je Meßbereich von den Sensoren (1) abgegebenen unterschiedlichen Stromausgangssignale ($I_K$) auf über alle Meßbereiche gleichgroße Spannungssignale gebracht,
(d) abgetastet und als digitalisierte Meßwerte zwecks Nachbildung eines Strom-Zeitverhaltens in einem Zeitfenster aufsummiert und nach der Berechnungsvorschrift

$$Mittelwert_{neu} = Mittelwert_{alt}*(1-1/n) + Mittelwert_{aktuell}*(1/m),$$

mit *n, m* als auslösezeitbestimmende Konstanten arithmetisch gemittelt werden und
(e) die Anordnung in einer Ausführung zur Anwendung kommt, die in Bauform und Funktionalität einem Bimetallrelais entspricht.

2. Schaltungsanordnung nach Anspruch 1, gekennzeichnet durch die Verwendung von magnetoresistiven Sensoren (1), insbesondere solchen mit integriertem Kompensationsleiter.

3. Schaltungsanordnung nach Anspruch 1, dadurch gekennzeichnet, daß zur Anpassung und Umsetzung der von den Sensoren (1) abgegebenen unterschiedlichen Stromausgangssignale ($I_K$) an den Eingangsbereich eines Analog/Digital-Wandlers (8) ein Widerstandsnetzwerk (5) dient.

4. Schaltungsanordnung nach Anspruch 1 und 3, dadurch gekennzeichnet, daß das Spannungsausgangssignal des Widerstandsnetzwerkes (5) mittels Wechselspannungsverstärker (9) gleichspannungsmäßig entkoppelt und auf einen zur Weiterverarbeitung notwendigen Pegel gebracht wird.

5. Schaltungsanordnung nach Anspruch 1 und 3, dadurch gekennzeichnet, daß durch Umschaltung des Stromausgangssignals ($I_K$) auf das Widerstandsnetzwerk (5) Nennstrombereiche über mindestens zwei Strombereichsdekaden realisierbar sind.

**6.** Schaltungsanordnung nach Anspruch 1, dadurch gekennzeichnet, daß mit der Meßbereichsumschaltung von Hand mittels des Umschalters (6) zugleich die Umsetzung der Stromausgangssignale ($I_K$) in gleichgroße Spannungssignale erfolgt.

**7.** Schaltungsanordnung nach Anspruch 1 bis 3, dadurch gekennzeichnet, daß die Sensoren (1) abwechselnd an das Widerstandsnetzwerk (5) geschaltet werden, wobei die Zuschaltzeit eines Sensors (1) vorzugsweise jeweils ca. 200-300 ms beträgt.

**8.** Schaltungsanordnung nach Anspruch 1, gekennzeichnet durch die Verwendung eines Mikroprozessors (10) zur Verarbeitung der digitalierten Meß- und Eingangssignale.

**9.** Schaltungsanordnung nach Anspruch 1 und 8, gekennzeichnet durch eine Beschaltung des Mikroprozessors (10) mit Schutzwiderständen und Ausnutzung seiner internen Schutzbeschaltung unter Verzicht auf eine vorangestellte Gleichrichtung.

**10.** Schaltungsanordnung nach Anspruch 1 und 8, gekennzeichnet dadurch, daß das vom Mikroprozessor (10) abgegebene Ausgangssignal eine Abschalteinrichtung (13), insbesondere ein Relais, beaufschlagt.

**11.** Schaltungsanordnung nach Anspruch 1 und 8, gekennzeichnet dadurch, daß das vom Mikroprozessor (10) abgegebene Ausgangssignal eine optische Signaleinrichtung (15) ansprechen läßt.

**12.** Schaltungsanordnung nach Anspruch 1, gekennzeichnet durch die Verwendung eines Potentiometers als Einstellelement (12) für die Einstellung des Auslösewertes.

**13.** Schaltungsanordnung nach Anspruch 1 und 12, dadurch gekennzeichnet, daß der Einstellknopf des Einstellelements (12) zwei Skalen trägt, die jede Meßbereichsdekade über den Faktor "Quadratwurzel aus 10" aufteilen.

**14.** Schaltungsanordnung nach Anspruch 1, dadurch gekennzeichnet, daß die zeitbestimmenden Konstanten *n, m* derartig gewählt sind, daß eine Strom-Zeit-Kennlinie nach IEC 947 nachgebildet wird.


**Claims**

**1.** Circuit for devices for measuring and monitoring electrical currents having a digital measuring data processing system, particularly for electronic overload relays, the monitored currents being detected by potential-separated sensors responsive to the magnetic field, appropriately evaluated, and an output signal being generated in function of said evaluation, characterized in that

(a) a plurality of switchable measuring ranges are provided in order to cover a large field of applications,
(b) a single analog adjusting means (12) serves for the adjustment in all measuring ranges,
(c) the current output signals ($I_K$) produced by said sensors (1), which differ according to the measuring range, are converted into voltage signals whose magnitude is the same in all measuring ranges,
(d) said voltage signals are sampled and summed up in the form of digitalised measuring data during a time window in order to simulate the behaviour of the current in time, and arithmetically averaged according to the formula

$$\text{mean value}_{new} = \text{mean value}_{old} \cdot (1\text{-}1/n) + \text{mean value}_{actual} \cdot (1/m),$$

wherein n, m are constants determining the release time, and
(e) the circuit is applied in an embodiment whose shape and function correspond to a thermorelay.

**2.** Circuit according to claim 1, characterised by the use of magnetoresistive sensors (1), more particularly such having an integrated compensation conductor.

**3.** Circuit according to claim 1, characterised in that a resistor network is provided for the purpose of adapting and converting said different current output signals ($I_K$) of the sensors (1) to the input range of an analog-digital converter (8).

4. Circuit according to claims 1 and 3, characterised in that the voltage output signal of said resistor network (5) is d.c. voltage uncoupled by means of an a.c. voltage amplifier (9) and brought to such a level as required for further processing.

5. Circuit according to claims 1 and 3, characterised in that nominal current ranges covering at least two current range decades are possible by switching the current output signal ($I_K$) to said resistor network (5).

6. Circuit according to claim 1, characterised in that the conversion of said current output signals ($I_K$) into voltage signals of equal magnitude is preferably effected simultaneously when the measuring range is manually changed by means of said switch (6).

7. Circuit according to claims 1 to 3, characterised in that said sensors (1) are alternatingly connected to said resistor network (5), the connecting time of each sensor (1) being in the range of 200 to 300 ms.

8. Circuit according to claim 1, characterised by the use of a microprocessor (10) for the prupose of processing the digitised measuring and input signals.

9. Circuit according to claims 1 and 8, characterised in that said microprocessor (10) is connected to protective resistances and its internal protective circuitry is used while a preceding rectification stage is omitted.

10. Circuit according to claims 1 and 8, characterised in that the output signal supplied by said microprocessor (10) actuates a cutoff device (13), more particularly a relay.

11. Circuit according to claims 1 and 8, characterised in that the output signal supplied by said microprocessor (10) triggers an optical signalling device (15).

12. Circuit according to claim 1, characterised by the use of a potentiometer as an adjusting element (12) for the adjustment of the releasing value.

13. Circuit according to claims 1 and 12, characterised in that the adjusting knob of said adjusting element (12) is provided with two scales dividing each decade of the measuring range by the factor "square root of 10".

14. Circuit according to claim 1, characterised in that the time-determining constants n, m are selected in such a manner that a current-time-characteristic according to IEC 947 is obtained.


**Revendications**

1. Circuit pour dispositifs de mesure et de contrôle de courants électriques comprenant un système de traitement des données de mesure digital, particulièrement pour relais de surcharge électroniques, les courants surveillés étant détectés à potentiels séparés par des capteurs répondant au champ magnétique, évalués de manière appropriée, et un signal de sortie étant généré en fonction de cette évaluation, caractérisé en ce que

(a) plusieurs domaines de mesure commutables sont prévus afin de couvrir un champ d'applications étendu,
(b) un seul moyen de réglage (12) analogique sert au réglage dans tous les domaines de mesure,
(c) les signaux de sortie de courant ($I_K$) fournis par lesdits capteurs (1), différents selon le domaine de mesure, sont convertis en signaux de tension dont la grandeur est égale dans tous les domaines de mesure,
(d) ces signaux de tension sont échantillonnés et additionnés sous forme de valeurs de mesure numérisés pendant un intervalle de temps afin de simuler l'allure du courant dans le temps, et la moyenne arithmétique en est calculée selon la formule

$$\text{moyenne}_{nouvelle} = \text{moyenne}_{ancienne} \cdot (1\text{-}1/n) + \text{moyenne}_{actuelle} \cdot (1/m),$$

où n, m sont des constantes déterminant le temps de déclenchement, et
(e) le circuit est appliqué dans une exécution dont la forme et la fonction correspondent à un relais thermique.

2. Circuit selon la revendication 1, caractérisé par l'utilisation de capteurs (1) magnétorésistifs, plus particulièrement de la sorte qui présente un conducteur de compensation intégré.

3. Circuit selon la revendication 1, caractérisé en ce qu'un réseau de résistances (5) sert à l'adaptation et à la conversion des différents signaux de sortie de courant ($I_K$) au domaine d'entrée d'un convertisseur analogique-numérique (8).

4. Circuit selon les revendications 1 et 3, caractérisé en ce que le signal de sortie de tension dudit réseau de résistances (5) est découplé en courant continu et amené au niveau nécessaire pour le traitement ultérieur au moyen d'un amplificateur de tension alternative (9).

5. Circuit selon les revendications 1 et 3, caractérsié en ce que des gammes de courants nominaux s'étendant sur au moins deux décades d'un domaine de courants sont réalisables en commutant ledit signal courant de sortie ($I_K$) sur ledit réseau de résistances (5).

6. Circuit selon la revendication 1, caractérisé en ce que ladite conversion des signaux de sortie du courant ($I_K$) en signaux de tension de grandeur égale est effectuée simultanément lors de la commutation manuelle des domaines de mesure.

7. Circuit selon les revendicatios 1 à 3, caractérisé en ce que les capteurs (1) sont connectés de manière alternante au réseau de résistances (5), le temps de connexion préféré de chaque capteur (1) étant dans l'ordre de 200 à 300 ms.

8. Circuit selon la revendication 1, caractérisé par l'utilisation d'un microprocesseur (10) pour le traitement des signaux de mesure et d'entrée numérisés.

9. Circuit selon les revendications 1 et 8, caractérisé par le fait que ledit microprocesseur (10) est connecté par l'intermédiaire de résistances protectrices, et que ses circuits de protection internes sont utilisés, alors qu'une rectification précédante est omise.

10. Circuit selon les revendications 1 et 8, caractérisé en ce que le signal de sortie fourni par ledit microprocesseur (10) actionne un dispositif coupe-circuit (13), plus particulièrement un relais.

11. Circuit selon les revendications et 8, caractérisé en ce que le signal de sortie fourni par ledit microprocesseur (10) enclenche un dispositif de signalisation optique (15).

12. Circuit selon la revendication 1, caractérisé par l'utilisation d'un potentiomètre en tant qu'élément de réglage (12) pour le réglage de la valeur de déclenchement.

13. Circuit selon les revendications 1 et 12, caractérisé en ce que le bouton de réglage dudit élément de réglage (12) porte deux échelles divisant chaque décade du domaine de mesure par le facteur "racine carrée de 10".

14. Circuit selon la revendication 1, caractérisé en ce que les constantes n, m déterminant le temps, sont choisies de telle manière qu'une caractéristique courant-temps selon IEC 947 est obtenue.

Fig. 1

EP 0 669 691 B1

EP 0 669 691 B1

Fig. 2

10

34

35

31

33

32

Fig. 3